# EUROPÄISCHE PATENTSCHRIFT

(11) **EP 1 883 119 B1**
(45) Veröffentlichungstag und Bekanntmachung des Hinweises auf die Patenterteilung: **04.11.2015**
(21) Anmeldenummer: 07013823.5
(22) Anmeldetag: 13.07.2007
(51) Int. Cl.: H01L 33/04, H01L 29/15, H01S 5/343

(54) **Halbleiter-Schichtstruktur mit Übergitter**
Semiconductor layer structure with overlay grid
Structure de recouvrement semi-conductrice dotée d'une surgrille

(30) Priorität: 27.07.2006 DE 102006034822; 29.09.2006 DE 102006046228
(43) Veröffentlichungstag der Anmeldung: 30.01.2008
(73) Patentinhaber: OSRAM Opto Semiconductors GmbH, 93055 Regensburg (DE)
(72) Erfinder: Eichler, Christoph, Dr., 93105 Tegernheim (DE); Lell, Alfred, 93142 Maxhütte-Haidhof (DE); Miler, Andreas, 86916 Kaufering (DE); Schillgalies, Marc, 12049 Berlin (DE)
(74) Vertreter: Epping - Hermann - Fischer

(56) Entgegenhaltungen:
- EP-A- 0 874 403
- EP-A- 1 215 781
- WO-A-00/58999
- WO-A-2004/084366
- JP-A- 10 022 524
- JP-A- 2000 091 708
- JP-A- 2000 244 070
- US-A- 4 839 899
- US-A1- 2003 118 066

## Beschreibung

Die Erfindung betrifft eine Halbleiter-Schichtstruktur, die eine aktive Schicht und ein Übergitter aus gestapelten Schichten eines ersten und mindestens eines zweiten Typs aufweist, wobei die Schichten des ersten Typs und des mindestens einen zweiten Typs III-V Verbindungshalbleiter sind, im Übergitter benachbarte Schichten unterschiedlichen Typs sich in der Zusammensetzung in mindestens einem Element unterscheiden und die Schichten vorgegebene Schichtdicken haben. Die Erfindung betrifft weiterhin ein optoelektronisches Bauelement, das eine derartige Halbleiter-Schichtstruktur aufweist.

Verglichen mit einer Schicht gleicher Dicke aus nur einem Material einer Zusammensetzung haben Übergitter mit gestapelten Schichten verschiedenen Typs unterschiedliche elektrische, optische und epitaktische Eigenschaften. Insbesondere kann bei geeigneter Zusammensetzung und Dotierung ein Übergitter aus alternierend gestapelten p-dotierten Gallium-Nitrid- (GaN) und p-dotierten Aluminium-Gallium-Nitrid- (AlGaN) Schichten eine höhere Leitfähigkeit aufweisen als eine p-dotierte reine GaN- oder AlGaN-Schicht der gleichen Dicke. Aufgrund dieser Eigenschaften finden Übergitter vielfach Verwendung in elektronischen und optoelektronischen Bauteilen.

Halbleiter-Schichtstrukturen, die ein Übergitter aufweisen, sind beispielsweise aus den Druckschriften EP 0 874 403, WO 00/58999, WO 2004/084366, US 4 839 899 und JP 10 022524 bekannt.

Aufgabe der Erfindung ist es, eine Halbleiter-Schichtstruktur mit Übergitter der eingangs genannten Art mit verbesserten elektrischen und optischen Eigenschaften zu schaffen. Es ist eine weitere Aufgabe der Erfindung, ein optoelektronisches Bauelement mit einer solchen Halbleiterschichtstruktur anzugeben.

Diese Aufgabe wird gemäß Patentanspruch 1 durch eine Halbleiter-Schichtstruktur der eingangs genannten Art gelöst, bei der die Schichtdicken der Schichten des ersten Typs und der Schichten des zweiten Typs sowie der Gehalt einer Materialkomponente in zumindest den Schichten eines gleichen Typs mit wachsendem Abstand von der aktiven Schicht von Schicht zu Schicht ansteigen.

Die Schichtdicke der Schichten eines Übergitters beeinflusst seine elektrischen, optischen und epitaktischen Eigenschaften. Häufig sind die gegebenen Erfordernisse an das Übergittern nicht über seine gesamte Dicke gleich, beispielsweise weil physikalische Größen, wie eine elektrische oder optische Feldstärke, die Einfluss auf die Erfordernisse haben, ebenfalls über die Dicke des Übergitters nicht konstant sind. Mit einem Übergitter mit einer von Schicht zu Schicht ansteigenden Schichtdicke mit wachsendem Abstand von der aktiven Schicht innerhalb der Schichten eines ersten und eines zweiten Typs kann dieser Tatsache Rechnung getragen werden und die Eigenschaften des Übergitters können bestmöglich an gegebene, insbesondere räumlich variierende Erfordernisse angepasst werden.

Beispielsweise kann die Dicke der Schichten eines Übergitters sich auf die elektrische Leitfähigkeit, die Höhe der optischen Absorption, die Größe der Bandlücke und die Wärmeleitfähigkeit auswirken. Dabei können die Abhängigkeiten der Größen von der Schichtdicke bezüglich gewünschter Eigenschaften des Übergitters gegenläufig sein. Beispielsweise führen dünne Schichten im Übergitter aufgrund einer durch Quantisierungseffekte vergrößerten Bandlücke vorteilhaft zu einer geringeren Absorption, aber auch zu einer geringeren Wärmeleitung in vertikaler Richtung aufgrund der größeren Anzahl von Grenzschichten im Übergitter und zu einer geringeren lateralen elektrischen Leitfähigkeit.

Eine gleiche Dicke aller Schichten im Übergitter kann in einem solchen Fall bestenfalls ein Kompromiss zwischen erreichbaren Vorteilen und in Kauf zu nehmenden Nachteilen darstellen. Durch die innerhalb des Übergitters variierenden Schichtdicken kann räumlich unterschiedlichen Anforderungen an das Übergitter dagegen Rechnung getragen werden. Beispielsweise können Schichten, die einer strahlungserzeugenden Schicht der Halbleiter-Schichtstruktur benachbart sind, bevorzugt in einer geringeren Dicke ausgeführt sein, um optische Absorptionsverluste zu verringern, als weiter entfernt liegende Schichten, die dafür eine höhere laterale Leitfähigkeit aufweisen, was vorteilhaft zu einer lateralen Homogenisierung des Stromflusses führt.

Grundsätzlich wird als Übergitter eine Struktur bezeichnet, die eine Periodizität aufweist, deren Periodenlänge größer ist als die Gitterkonstanten eingesetzter Materialien. Im Rahmen der Anmeldung wird als Übergitter eine Folge gestapelter Schichten bezeichnet, bei der sich in einer Richtung senkrecht zu den Grenzflächen zwischen den Schichten, also z.B. in Aufwachsrichtung der Schichten, eine Schichtabfolge, umfassend mindestens zwei Schichten unterschiedlichen Typs, wiederholt. Ein Übergitter in diesem Sinne ist beispielsweise durch eine Folge alternierend gestapelter Schichten verschiedener Typen gegeben, wobei alternierend so zu verstehen ist, dass sich zwei oder mehr Schichten abwechseln. Innerhalb der sich wiederholenden Schichtabfolge kann dabei ein Typ durch mehr als eine Schicht vertreten sein. Beispiele für derartige Übergitter sind durch die folgenden Schichtenfolgen gegeben: "ab|ab|ab|...", "abc|abc|abc|...", "abcb|abcb|..." und "ababababc|ababababc|...", wobei a, b und c jeweils Schichten eines Typs angeben und die sich wiederholende Schichtenabfolge durch das Trennzeichen "|" verdeutlicht ist.

Im Rahmen der Anmeldung ist die Zusammensetzung einer Schicht durch in der Schicht enthaltene Elemente sowie ihre nominelle (d.h. im Rahmen der Genauigkeit der Kompositionsüberwachung während oder nach dem Wachstumsprozess) Stöchiometrie definiert, wobei Dotierstoffe und Verunreinigungen nicht mitberücksichtigt werden. Die Stöchiometrie ist durch den Gehalt (Anteil) der einzelnen Elemente in der Schicht gegeben. Für die Anzahl der Elemente einer Schicht besteht im Rahmen der Anmeldung keine Begrenzung. Die Schichten des Übergitters können z.B. elementar sein, d.h. nur aus einem Element bestehen, oder auch binär, ternär, quaternär usw. sein.

Der Typ einer Schicht ist durch die Zusammensetzung der Schicht gegeben, wobei das jedoch nicht zwangsläufig bedeutet, dass alle Schichten eines Typs die gleiche Zusammensetzung aufweisen. Die Zusammensetzung der Schichten eines Typs kann innerhalb des Übergitters in vorgegebener Weise variieren, z.B. indem die Konzentration eines Elements der Schichten eines Typs von Schicht zu Schicht dieses Typs anwächst. Im Übergitter benachbarte Schichten unterschiedlichen Typs unterscheiden sich jedoch in ihrer Zusammensetzung in mindestens einem Element.

Gemäß vorteilhafter Ausgestaltungen der Halbleiter-Schichtstruktur weist das Übergitter alternierend gestapelte InₓAl_{y}Ga_{1-x-y}N- und In_{w}Al_{z}Ga_{1-w-z}N-Schichten mit 0≤x,y,w,z≤1 und x+y≤1 und w+z≤1 oder alternierend gestapelte InₓAl_{y}Ga_{1-x-y}P und In_{w}Al_{z}Ga_{1-w-z}P Schichten mit 0≤x,y,w,z≤1 und x+y≤1 und w+z≤1 oder alternierend gestapelte InₓAl_{y}Ga_{1-x-y}As und In_{w}Al_{z}Ga_{1-w-z}As Schichten mit 0≤x,y,w,z≤1 und x+y≤1 und w+z≤1 auf. Diese Materialsysteme sind zum einen von großer technologischer Bedeutung und zum anderen kann in diesen Systemen eine vorteilhafte Leitfähigkeitserhöhung insbesondere der Löcherleitung durch den Einsatz eines Übergitters beobachtet werden.

Gemäß einer weiteren vorteilhaften Ausgestaltung der Halbleiter-Schichtstruktur ist den einzelnen Schichten des Übergitters eine vertikale Position innerhalb der Halbleiter-Schichtstruktur zugeordnet und die Dicke einer Schicht ist in vorgegebener Weise abhängig von ihrer vertikalen Position innerhalb der Halbleiter-Schichtstruktur. Auf diese Weise kann das Übergitter und seine Eigenschaften bestmöglich an räumlich unterschiedliche Anforderungen angepasst werden.

Gemäß weiterer vorteilhafter Ausgestaltungen ist die Abhängigkeit der Schichtdicke einer Schicht von der vertikalen Position entweder für alle Schichten durch eine gemeinsame Funktion vorgegeben oder sie ist für Schichten des ersten Typs durch eine erste Funktion und für Schichten des mindestens einen zweiten Typs durch eine mindestens eine zweite Funktion vorgegeben. Besonders bevorzugt ist dabei die erste und/oder die mindestens eine zweite und/oder die gemeinsame Funktion eine Stufenfunktion oder eine monoton steigende/fallende Funktion oder eine lineare Funktion oder eine Polynomfunktion oder eine Wurzelfunktion oder eine exponentielle Funktion oder eine logarithmische Funktion oder eine periodische Funktion oder eine Superposition der genannten Funktionen oder enthält Anteile einer dieser Funktionen.

Gemäß einer weiteren vorteilhaften Ausgestaltung weisen zumindest die Schichten eines gleichen Typs innerhalb des Übergitters eine unterschiedliche Zusammensetzung auf. Damit können die elektrischen, optischen und epitaktischen Eigenschaften des Übergitters bestmöglich an gegebene Erfordernisse angepasst werden.

Erfindungsgemäß steigen sowohl die Schichtdicken der Schichten des ersten Typs und der Schichten des zweiten Typs als auch der Gehalt einer Materialkomponente in zumindest den Schichten eines gleichen Typs mit wachsendem Abstand von der aktiven Schicht von Schicht zu Schicht an. Durch die kontinuierliche Variation der Schichtdicken können die Eigenschaften des Übergitters bestmöglich an räumlich unterschiedliche Anforderungen an das Übergitter, z.B. bezüglich seiner optischen Absorption, seiner lateralen oder vertikalen elektrischen Leitfähigkeit oder seiner Wärmeleitfähigkeit, angepasst werden. Durch die Kombination der Schichtdickenvariation mit einer Variation der Materialzusammensetzung, die ebenfalls Auswirkungen auf die genannten Eigenschaften haben kann, können vorteilhafte Effekte weiter verstärkt werden.

Die Aufgabe wird weiterhin durch ein optoelektronisches Bauelement gelöst, das eine Halbleiterschichtstruktur der zuvor beschriebenen Art aufweist. In einem optoelektronischen Bauelement sind die Anforderungen an bestimmte Eigenschaften des Übergitters häufig räumlich nicht konstant. Durch eine Halbleiterschichtstruktur mit einer nicht gleichen Zusammensetzung bei Schichten gleichen Typs innerhalb des Übergitters, können die elektrischen, optischen und epitaktische Eigenschaften des Übergitters bestmöglich an gegebene Erfordernisse angepasst werden.

Gemäß weiterer vorteilhafter Ausgestaltungen ist das optoelektronische Bauelement eine Leuchtdiode oder eine Laserdiode.

Weitere vorteilhafte Ausgestaltungen der Erfindung ergeben sich aus den im Folgenden in Verbindung mit den in den Figuren beschriebenen Ausführungsbeispielen.

Es zeigen:
- Figur 1: eine Querschnittszeichnung eines optoelektronischen Bauelements mit einer erfindungsgemäßen Halbleiterschichtstruktur mit Übergitter und
- Figur 2: schematische Darstellungen des Gehalts eines Elements abhängig von einer vertikalen Position in einem Übergitter bei zwei verschiedenen Beispielen (Figur 2a nicht erfindungsgemäß und Figur 2b erfindungsgemäß eines Übergitters einer Halbleiter-Schichtstruktur.

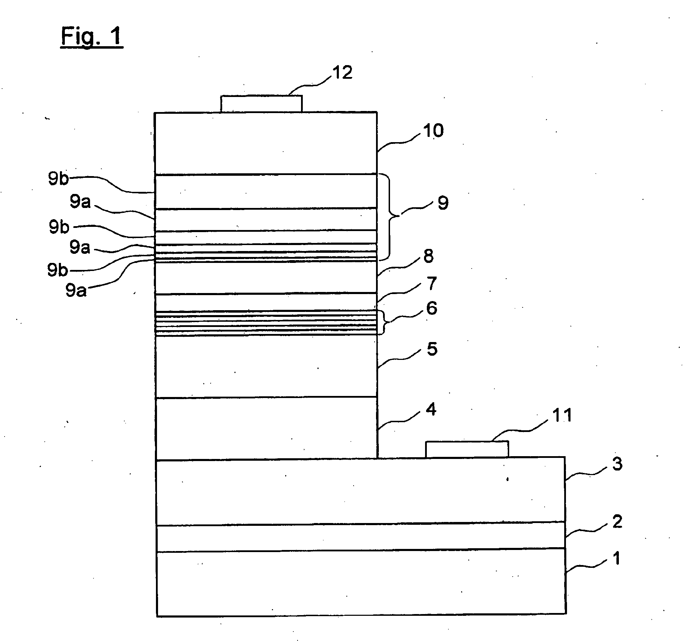

In Figur 1 ist die Schichtenfolge einer Halbleiter Schichtstruktur eines optoelektronischen Bauelements mit einem Übergitter im Querschnitt schematisch dargestellt. Auf einem Substrat 1 sind eine Anpassungsschicht 2 und folgend eine n-dotierte Kontaktschicht 3 aufgewachsen. Zur einfacheren Darstellung wird der Dotierungstyp von Schichten im Folgenden durch Voranstellen des Buchstabens n oder p angegeben, also z. B. n-Kontaktschicht 3.

Auf der n-Kontaktschicht 3 befindet sich eine n-Mantelschicht 4 und eine n-Wellenleiterschicht 5. Auf diese ist eine aktive Schicht 6 aufgebracht, anschließend eine Barriereschicht 7 sowie eine p-Wellenleiterschicht 8. Es folgt eine p-Mantelschicht, die als Übergitter 9 ausgeführt ist. Das Übergitter 9 weist die alternierend gestapelten Schichten 9a eines ersten Typs a und Schichten 9b eines zweiten Typs b auf.

Auf das Übergitter 9 ist eine p-Kontaktschicht 10 aufgewachsen. Im rechten Bereich ist die Schichtenfolge durch Abätzen bis auf eine dem Substrat abgewandte Fläche der n-Kontaktschicht 3 abgetragen, beziehungsweise wurde in diesem Bereich durch Maskierung erst gar nicht aufgebaut. Auf der freiliegenden Fläche der n-Kontaktschicht 3 ist ein n-Kontakt 11 aufgebracht. Auf der p-Kontaktschicht 10 befindet sich ein p-Kontakt 12.

Die Figur 1 ist als schematische Zeichnung zu verstehen. Insbesondere sind die gezeigten Schichtdicken nicht maßstabsgetreu.

Das gezeigte Ausführungsbeispiel kann beispielsweise auf Basis des InₓAl_{y}Ga_{1-x-y}N, InₓAl_{y}Ga_{1-x-y}As, InₓAl_{y}Ga_{1-x-y}P oder InₓGa₁₋ₓAs_{y}N_{1-y} mit 0≤x≤1, 0≤y≤1, 0≤x+y≤1 Materialsystems realisiert werden. Selbstverständlich ist die Erfindung nicht auf diese Materialsysteme beschränkt, sondern kann je nach gewünschter Wellenlänge oder sonstige Anforderung auch auf Basis weiterer Materialsysteme aufgebaut sein.

Das in Figur 1 gezeigte Bauelement stellt eine Doppel-Heterostruktur Laserdiode dar. Im Folgenden ist beispielhaft eine Realisierung im InₓAl_{y}Ga_{1-x-y}N Materialsystem näher beschrieben. In einem solchen Fall kann Saphir als Substrat 1 Verwendung finden und n-dotiertes GaN als n-Kontaktschicht 3 eingesetzt werden. Zur n-Dotierung der GaN-Schicht wird vorzugsweise Silizium (Si) eingesetzt. Als Anpassungsschicht 2 ist typischerweise eine Aluminiumnitrid (AlN) Schicht zwischen dem Saphir-Substrat 1 und der GaN n-Kontaktschicht 3 zur Anpassung der unterschiedlichen Gitterkonstanten dieser Schicht vorgesehen.

Analog kann die p-Kontaktschicht 10 durch eine mit Magnesium (Mg) p-dotierte GaN-Schicht realisiert werden, wobei eine durch die Magnesiumstörstellen induzierte Löcherleitung nach Aufwachsen der Schicht in bekannter Weise aktiviert wird, z.B. durch Elektronenbestrahlung oder thermische Behandlung. Als n- oder p-Kontakte 11 bzw. 12 können Elektroden, z.B. aus Aluminium oder Nickel, auf die entsprechenden n- oder p-Kontaktschichten 3 bzw. 10 aufgedampft werden. Das zu dem Zweck erforderliche Freilegen der n-Kontaktschicht 3 kann beispielsweise durch einen Trockenätzprozess in Chlorgas oder durch Argon-Ionen-Sputtern erfolgen.

Alternativ kann statt eines nicht leitenden Substrats 1 ein leitendes Substrat, wie z.B. Galliumnitrid (GaN) oder Siliziumkarbid (SiC), eingesetzt werden. In einem solchen Fall kann die n-Kontaktschicht 3 und gegebenenfalls, z.B. beim Einsatz von GaN, die Anpassungsschicht 2 entfallen. Der n-Kontakt 11 kann dann gegenüber dem p-Kontakt 12 auf der der Halbleiter-Schichtstruktur abgewandten Seite des Substrats aufgebracht werden, so dass eine vertikal leitende Halbleiter-Schichtstruktur gebildet wird.

Ohne Einschränkung ist in der Figur 1 ein Ausführungsbeispiel gezeigt, bei dem zunächst n-dotierte Schichten auf das Substrat 1 aufgebracht sind. Eine Anordnung, bei der p-dotierte Schichten näher am Substrat 1 angeordnet sind als die n-dotierten Schichten, ist ebenso möglich. Die beiden Ausführungen können bezüglich der Ladungsträgerinjektion in die Halbleiterschichtstruktur unterschiedliche Eigenschaften aufweisen. Abhängig von den gewünschten Eigenschaften kann sich jede der Ausführungen im Einzelfall als vorteilhaft erweisen.

Die aktive Schicht 6 kann z.B. eine Einfach- oder Mehrfach-Quantenschichtstruktur sein, bei der Indium-Galliumnitrid (InGaN)-Quantenschichten abwechselnd mit AlGaN-Barriereschichten gestapelt sind.

Als Quantenschicht ist im Rahmen der Erfindung eine Schicht zu verstehen, die so dimensioniert oder strukturiert ist, dass eine für die Strahlungserzeugung wesentliche Quantisierung der Ladungsträger-Energieniveaus, zum Beispiel durch Einschluss (confinement), auftritt. Insbesondere beinhaltet die Bezeichnung Quantenschicht keine Angabe oder Einschränkung über die Dimensionalität der Quantisierung. Die Quantenschicht kann einen zweidimensionalen Quantentopf bilden oder strukturelle Elemente mit niedrigerer Dimensionalität wie Quantendrähte oder Quantenpunkte oder Kombinationen dieser Strukturen enthalten.

Darüber hinaus ist auch der Einsatz einer Fotolumineszenzaktiven Schicht, z. B. einer Fremdatom-dotierten InGaN-Schicht als aktive Schicht 6 denkbar.

Die die aktive Schicht 6 umgebenden Schichten (n- und p-Wellenleiterschichten 5 bzw. 8, n-Mantelschicht 4, Übergitter 9 als p-Mantelschicht und Barriereschicht 7) haben eine größere Bandlücke als die aktiven Schicht 6. Dieses bewirkt eine Konzentration oder eine Eingrenzung, auch confinement genannt, von Ladungsträgern auf die aktive Schicht 6. Die Anzahl der zu diesem Zweck vorgesehenen Schichten ist nicht auf die in der Figur gezeigte Anzahl von fünf Schichten festgelegt, sondern prinzipiell beliebig.

Weiterhin bilden die die aktive Schicht 6 umgebenden Schichten einen Wellenleiter für die in der aktiven Schicht 6 erzeugte Strahlung. Gute Wellenführungseigenschaften werden erreicht, wenn der Brechungsindex in einer Richtung senkrecht zur aktiven Schicht 6 von dieser aus nach außen abnimmt. Da GaN einen höheren Brechungsindex aufweist als AlGäN, sind die näher an der aktiven Schicht 6 angeordneten n- und p-Wellenleiterschichten 5 bzw. 8 im Ausführungsbeispiel als GaN-Schichten ausgeführt. Die n-Mantelschicht 4 und das Übergitter 9 als p-Mantelschicht sind bevorzugt aluminiumhaltig.

Auf der dem Substrat 1 zugewandten Seite der aktiven Schicht 6 (n-dotierte Seite) kann die Wellenleiterschicht 5 folglich als eine Si-dotierte GaN-Schicht ausgeführt sein und die Mantelschicht 4 entsprechend als eine Si-dotierte AlGaN-Schicht. Auf der dem Substrat 1 abgewandten Seite der aktiven Schicht 6 (p-dotierte Seite) wird analog eine Magnesium (Mg)-dotierte GaN-Schicht als Wellenleiterschicht 8 eingesetzt. Um eine direkte Rekombination von Elektronen, die aus der aktiven Schicht 6 in die Wellenleiterschicht 8 diffundieren, mit den dort befindlichen Löchern zu verhindern, ist zwischen beiden Schichten zusätzlich die Barriereschicht 7 vorgesehen. Diese kann durch eine AlGaN-Schicht realisiert sein, die typischerweise deutlich dünner als die n- und p-Wellenleiterschichten 5 bzw. 8, die n-Mantelschicht 4 oder das Übergitter 9 ausgeführt ist.

Die p-seitige Mantelschicht wird durch das Übergitter 9 realisiert.

Im Ausführungsbeispiel der Figur 1 ist das Übergitter 9 durch abwechselnd angeordnete Schichten 9a des ersten Typs a und Schichten 9b des zweiten Typs b gebildet. Beispielhaft und wegen einer übersichtlicheren Darstellung sind in der Figur nur je 3 Schichten der zwei verschiedenen Typen a und b gezeigt. In tatsächlichen Umsetzungen der Erfindung weist das Übergitter üblicherweise eine größere Anzahl von Schichten auf, beispielsweise mehrere zehn bis einige hundert Schichten jeder Zusammensetzung. Typische Schichtdicken für eine einzelne Schicht des Übergitters 9 liegen im Bereich von wenigen nm bis hin zu mehreren zehn nm.

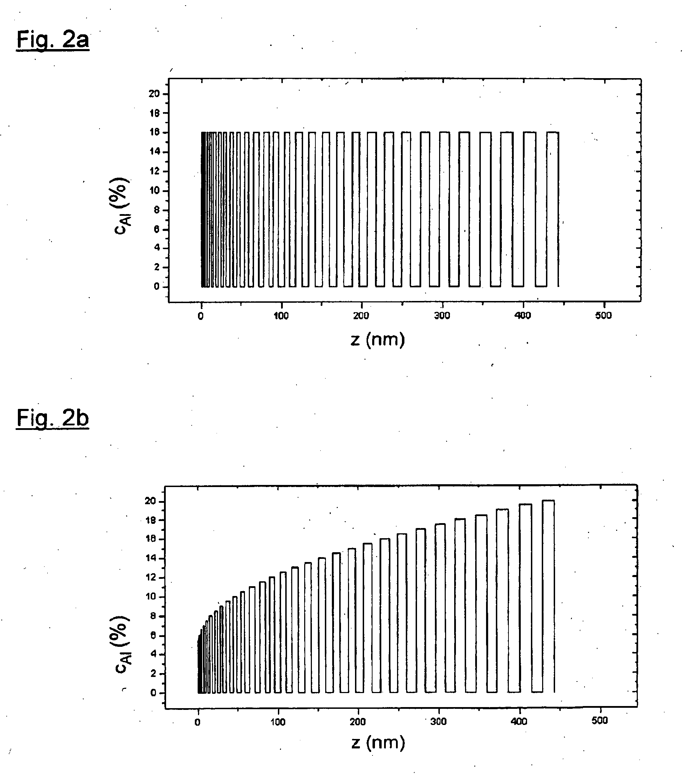

Die Schichtdicken sowohl der Schichten 9a des ersten Typs a als auch der Schichten 9b des zweiten Typs b sind innerhalb des Übergitters 9 nicht konstant, sondern steigen mit wachsendem Abstand von der aktiven Schicht 6 von Schicht zu Schicht an. Detaillierte Beschreibungen von Übergittern, bei denen die Schichtdicke innerhalb der Schichten zumindest eines Typs variiert, werden im Zusammenhang mit den Ausführungsbeispielen der Figur 2 gegeben.

Im GaN-basierten Materialsystem kann das Übergitter 9 als p-Mantelschicht z.B. aus alternierenden Mg-dotierten GaN-Schichten und Mg-dotierten AlGaN-Schichten bestehen. Aufgrund der hohen Aktivierungsenergie der Mg-Dotieratome ist die elektrische Leitfähigkeit von p-dotierten Schichten gering. Zudem hat AlGaN eine größere Bandlücke als GaN und weist aufgrund einer geringeren Dotiereffizienz eine geringere Leitfähigkeit auf. Die Dotiereffizienz gibt an, in welcher Konzentration Dotierstoffe überhaupt vom Material aufgenommen werden und welcher Anteil aufgenommener Dotieratome prinzipiell (d.h. unbeachtlich temperaturbedingter Besetzungseffekte) überhaupt zur Leitfähigkeit beitragen kann. Die Dotiereffizienz ist unter anderem davon abhängig, welche Gitter- oder Zwischengitterplätze die Dotieratome einnehmen.

Durch den Einsatz höher und effizienter dotierbarer und somit leitfähigerer GaN-Schichten kann das Übergitter 9 verglichen mit einer p-dotierten reinen AlGaN-Mantelschicht eine erhöhte Leitfähigkeit bei effektiv gleichem Brechungsindex aufweisen. Ein effektiv gleicher Brechungsindex kann durch einen erhöhten Aluminiumgehalt der im Übergitter 9 eingesetzten AlGaN-Schichten verglichen mit der AlGaN-Mantelschicht erreicht werden.

Statt eines GaN-/AlGaN-Übergitters 9 ist ebenso ein Übergitter 9 denkbar, in dem AlₓGa₁₋ₓN/Al_{y}Ga_{1-y}N-Schichten mit 0≤x,y≤1 und x≠y abwechselnd gestapelt sind. Weiterhin ist auch für die n-dotierte AlGaN-Mantelschicht 4 der Einsatz eines Übergitters denkbar. Aufgrund der im Allgemeinen höheren Leitfähigkeit von n-dotierten Schichten liegt in diesem Fall ein Vorteil nicht primär in einer erhöhten vertikalen Leitfähigkeit. Vorteile ergeben sich jedoch durch eine mögliche Verringerung von Verspannungen, die in der aktiven Schicht 6 induziert werden. Ein weiterer Vorteil, der insbesondere bei seitlicher Stromeinbringung zum Tragen kommt, liegt in der erhöhten lateralen Stromleitfähigkeit eines Übergitters begründet.

In der Figur 2 sind zwei Beispiele eines Übergitters dargestellt, das alternierend gestapelte Schichten eines ersten Typs a und eines zweiten Typs b enthält. Die Schichten des Typs a sind GaN-Schichten, die alle die gleiche Zusammensetzung aufweisen. Die Schichten des Typs b sind AlGaN-Schichten, im ersten Fall gleicher Zusammensetzung (Figur 2a nicht erfindungsgemäß), im zweiten Fall unterschiedlicher Zusammensetzung (Figur 2b erfindungsgemäß).

Die Übergitter werden jeweils durch ein Diagramm charakterisiert, in dem der Al-Gehalt c_{Al} in Prozent (Ordinate) abhängig von einer vertikalen Position z innerhalb des Übergitters einer Halbleiter-Schichtstruktur (Abszisse) angegeben ist. Als Nullpunkt der vertikalen Position z innerhalb des Übergitters ist die Seite des Übergitters gewählt, die einer aktiven Schicht zugewandt ist. Die aktive Schicht liegt folglich links vom dargestellten Bereich des Übergitters bei negativen Werten der vertikalen Position z. Die bei z=0 beginnende, der aktiven Schicht am nächsten liegende Schicht des Übergitters ist vom Typ a.

In Figur 2a ist ein Übergitter mit je 30 Schichten jeden Typs a und b gezeigt. Die Schichten vom Typ a sind GaN-Schichten und die Schichten vom Typ b sind AlGaN-Schichten mit einem konstanten Al-Gehalt von 16 %. Die Dicke der Schichten beider Schichttypen variiert, jedoch nicht sprunghaft, sondern kontinuierlich. Die Schichtdicke wächst dabei von Schicht zu Schicht einen Typs um 0.5 nm an. Es ergibt sich damit eine wurzelfunktionsförmige Abhängigkeit der Schichtdicke von der der vertikalen Position z.

Aufgrund von Quantisierungseffekten weisen dünne Schichten eine effektiv höhere Bandlücke und damit geringere optische Absorptionskoeffizienten auf. Dadurch, dass im Übergitter dünnere Schichten in dem der aktiven Schicht zugewandten Abschnitt, in dem im Betrieb der Halbleiter-Schichtstruktur typischerweise eine größere Strahlungsintensität herrscht, vorgesehen sind, werden Absorptionsverluste im Übergitter verringert. Der von der aktiven Schicht abgewandten Abschnitt des Übergitters ist typischerweise einer Kontaktschicht zur Stromeinprägung benachbart. Beispielsweise grenzt in Figur 1 das Übergitter 9 an die p-Kontaktschicht 10 an. Die in diesem Abschnitt eingesetzten dickeren Schichten weisen eine höhere laterale Leitfähigkeit auf, was vorteilhaft eine laterale Homogenisierung des vertikalen Stromflusses innerhalb der Halbleiterschichtstruktur unterstützt.

Verallgemeinert kann der Verlauf der Schichtdicke innerhalb eines Übergitters durch eine (Hüllkurven-) Funktion beschrieben werden, die die Dicke einer Schicht abhängig von der Position der Schicht angibt. Dabei kann entweder eine gemeinsame Funktion für alle Schichtentypen a, b, usw. vorgegeben sein, oder es kann für jeden Schichtentyp eine eigene Funktion vorgegeben sein. Prinzipiell ist dabei jeder beliebige, z.B. auch nichtlineare, Funktionsverlauf möglich.

Das in Figur 2b dargestellte Übergitter entspricht bezüglich der Schichtdicken dem Beispiel aus Figur 2a. Im Unterschied zum Beispiel aus Figur 2a ändert sich innerhalb der AlGaN-Schichten der Al-Gehalt von etwa 5 % auf der einer aktiven Schicht zugewandten Seite des Übergitters auf etwa 20 % auf der abgewandten Seite. Der Al-Gehalt steigt dabei ähnlich wie die Schichtdicke von Schicht zu Schicht um einen festen Betrag. Wenn der Al-Gehalt einer Schicht vom Typ b ebenfalls in Abhängigkeit der vertikalen Position z der Schicht angegeben wird, ergibt sich damit auch für den Al-Gehalt eine wurzelfunktionsförmige Abhängigkeit.

Durch die kontinuierliche Variation der Schichtdicke können die Eigenschaften des Übergitters bestmöglich an räumlich unterschiedliche Anforderungen an das Übergitter, z.B. bezüglich seiner optischen Absorption, seiner lateralen oder vertikalen elektrischen Leitfähigkeit oder seiner Wärmeleitfähigkeit, angepasst werden. Durch die Kombination der Schichtdickenvariation mit einer Variation der Materialzusammensetzung, die ebenfalls Auswirkungen auf die genannten Eigenschaften haben kann, können vorteilhafte Effekte weiter verstärkt werden.

Die Erläuterung der Erfindung anhand der beschriebenen Ausführungsbeispiele ist nicht als Beschränkung der Erfindung hierauf zu verstehen. Vielmehr umfasst die Erfindung auch die Kombination mit allen anderen in den Ausführungsbeispielen und der sonstigen Beschreibung genannten Merkmale, auch wenn diese Kombination nicht Gegenstand eines Patentanspruchs ist.

## Patentansprüche

1. Halbleiter-Schichtstruktur, umfassend eine aktive Schicht (6) und ein Übergitter (9) aus gestapelten Schichten (9a, 9b) eines ersten (a) und mindestens eines zweiten Typs (b), wobei
- die Schichten (9a, 9b) des ersten Typs (a) und des mindestens einen zweiten Typs (b) III-V Verbindungshalbleiter sind,
- im Übergitter (9) benachbarte Schichten unterschiedlichen Typs sich in der Zusammensetzung in mindestens einem Element unterscheiden,
- die Schichten vorgegebene Schichtdicken haben, und
- die Schichtdicken der Schichten (9a) des ersten Typs (a) und der Schichten (9b) des zweiten Typs (b) mit wachsendem Abstand von der aktiven Schicht (6) von Schicht zu Schicht ansteigen,
**dadurch gekennzeichnet, dass**
der Gehalt einer Materialkomponente in zumindest den Schichten eines gleichen Typs (9a, 9b) mit wachsendem Abstand von der aktiven Schicht (6) von Schicht zu Schicht ansteigt.

2. Halbleiter-Schichtstruktur nach Anspruch 1, bei der das Übergitter (9) alternierend gestapelte InₓAl_{y}Ga_{1-x-y}N und In_{w}Al_{z}Ga_{1-w-z}N Schichten mit 0≤x,y,w,z≤1 und x+y≤1 und w+z≤1 aufweist.

3. Halbleiter-Schichtstruktur nach Anspruch 1, bei der das Übergitter (9) alternierend gestapelte InₓAl_{y}Ga_{1-x-y}P und In_{w}Al_{z}Ga_{1-w-z}P Schichten mit 0≤x,y,w,z≤1 oder alternierend gestapelte InₓAl_{y}Ga_{1-x-y}As und In_{w}Al_{z}Ga_{1-w-z}As Schichten mit 0≤x,y,w,z≤1 und x+y≤1 und w+z≤1 aufweist.

4. Halbleiter-Schichtstruktur nach einem der Ansprüche 1 bis 3, bei der einzelnen Schichten des Übergitters (9) eine vertikale Position (z) innerhalb der Halbleiter-Schichtstruktur zugeordnet ist und die Schichtdicke einer Schicht abhängig von ihrer vertikalen Position (z) innerhalb der Halbleiter-Schichtstruktur ist, wobei die Abhängigkeit der Schichtdicke einer Schicht von der vertikalen Position (z) für alle Schichten des Übergitters (9) durch eine gemeinsame Funktion vorgegeben ist.

5. Halbleiter-Schichtstruktur nach einem der Ansprüche 1 bis 3, bei der einzelnen Schichten des Übergitters (9) eine vertikale Position (z) innerhalb der Halbleiter-Schichtstruktur zugeordnet ist und die Schichtdicke einer Schicht abhängig von ihrer vertikalen Position (z) innerhalb der Halbleiter-Schichtstruktur ist, wobei die Abhängigkeit der Schichtdicke einer Schicht von der vertikalen Position (z) für Schichten des ersten Typs (a) durch eine erste Funktion und für Schichten des mindestens einen zweiten Typs (b) durch mindestens eine zweite Funktion vorgegeben ist.

6. Halbleiter-Schichtstruktur nach einem der Ansprüche 4 oder 5, bei der die erste und/oder die mindestens eine zweite und/oder die gemeinsame Funktion eine Stufenfunktion oder eine monoton steigende/fallende Funktion oder eine lineare Funktion oder eine Parabelfunktion oder eine exponentielle Funktion oder eine logarithmische Funktion oder eine periodische Funktion oder eine Superposition der genannten Funktionen ist oder Anteile einer dieser Funktionen enthält.

7. Optoelektronisches Bauelement, das eine Halbleiter-Schichtstruktur nach einem der Ansprüche 1 bis 6 aufweist.

8. Optoelektronisches Bauelement nach Anspruch 7, das eine Leuchtdiode ist.

9. Optoelektronisches Bauelement nach Anspruch 7, das eine Laserdiode ist.

## Claims

1. Semiconductor layer structure, comprising an active layer (6) and a superlattice (9) composed of stacked layers (9a, 9b) of a first type (a) and of at least one second type (b), wherein
- the layers (9a, 9b) of the first type (a) and of the at least one second type (b) are III-V compound semiconductors,
- adjacent layers of different types in the superlattice (9) differ in composition in terms of at least one element,
- the layers have predefined layer thicknesses, and
- the layer thicknesses of the layers (9a) of the first type (a) and of the layers (9b) of the second type (b) increase from layer to layer with increasing distance from the active layer (6),
**characterized in that**
the content of a material component in at least the layers of an identical type (9a, 9b) increases from layer to layer with increasing distance from the active layer (6).

2. Semiconductor layer structure according to Claim 1, wherein the superlattice (9) has alternately stacked InₓAl_{y}Ga_{1-x-y}N and In_{w}Al_{z}Ga_{1-w-z}N layers where 0≤x,y,w,z≤1 and x+y≤1 and w+z≤1.

3. Semiconductor layer structure according to Claim 1, wherein the superlattice (9) has alternately stacked InₓAl_{y}Ga_{1-x-y}P and In_{w}Al_{z}Ga_{1-w-z}P layers where 0≤x,y,w,z≤1 or alternately stacked InₓAl_{y}Ga_{1-x-y}As and In_{w}Al_{z}Ga_{1-w-z}As layers where 0≤x,y,w,z≤1 and x+y≤1 and w+z≤1.

4. Semiconductor layer structure according to any of Claims 1 to 3, wherein individual layers of the superlattice (9) are assigned a vertical position (z) within the semiconductor layer structure and the layer thickness of a layer is dependent on its vertical position (z) within the semiconductor layer structure, wherein the dependence of the layer thickness of a layer on the vertical position (z) is predefined by a common function for all the layers of the superlattice (9).

5. Semiconductor layer structure according to any of Claims 1 to 3, wherein individual layers of the superlattice (9) are assigned a vertical position (z) within the semiconductor layer structure and the layer thickness of a layer is dependent on its vertical position (z) within the semiconductor layer structure, wherein the dependence of the layer thickness of a layer on the vertical position (z) is predefined by a first function for layers of the first type (a) and by at least one second function for layers of the at least one second type (b).

6. Semiconductor layer structure according to either of Claims 4 and 5, wherein the first and/or the at least one second and/or the common function are/is a step function or a monotonically rising/falling function or a linear function or a parabolic function or an exponential function or a logarithmic function or a periodic function or a superposition of the stated functions or contain(s) portions of one of these functions.

7. Optoelectronic component comprising a semiconductor layer structure according to any of Claims 1 to 6.

8. Optoelectronic component according to Claim 7, which is a light-emitting diode.

9. Optoelectronic component according to Claim 7, which is a laser diode.

## Revendications

1. Structure stratifiée semi-conductrice, comprenant une couche active (6) et une grille supérieure (9) constituée de couches empilées (9a, 9b) d'un premier (a) et d'au moins un deuxième (b) types, dans laquelle
- les couches (9a, 9b) du premier type (a) et dudit au moins un deuxième type (b) sont des semiconducteurs de liaison III-V,
- des couches de type différent voisines dans la grille supérieure (9) diffèrent dans leur composition par au moins un élément,
- les couches ont des épaisseurs de couche prédéfinies, et
- les épaisseurs de couche des couches (9a) du premier type et des couches (9b) du deuxième type (b) augmentent de couche en couche avec l'augmentation de la distance à la couche active (6),
**caractérisée en ce que** la teneur d'un composant du matériau dans au moins les couches d'un même type (9a, 9b) augmente de couche en couche avec l'augmentation de la distance à la couche active (6).

2. Structure stratifiée semi-conductrice selon la revendication 1, dans laquelle la grille supérieure (9) présente des couches de InₓAl_{y}Ga_{1-x-y}N et In_{w}Al_{z}Ga_{1-w-z}N empilées en alternance, avec 0≤x,y,z≤1 et x+y≤1 et w+z≤1.

3. Structure stratifiée semi-conductrice selon la revendication 1, dans laquelle la grille supérieure (9) présente des couches de InₓAl_{y}Ga_{1-x-y}P et In_{w}Al_{z}Ga_{1-w-z}P empilées en alternance avec 0≤x,y,z≤1 ou des couches de InₓAl_{y}Ga_{1-x-y}As et In_{w}Al_{z}Ga_{1-w-z}As empilées en alternance avec 0≤x,y,z≤1 et x+y≤1 et w+z≤1.

4. Structure stratifiée semi-conductrice selon l'une quelconque des revendications 1 à 3, dans laquelle une position verticale (z) est associée à des couches individuelles de la grille supérieure (9) à l'intérieur de la structure stratifiée semi-conductrice et l'épaisseur de couche d'une couche dépend de sa position verticale (z) à l'intérieur de la structure stratifiée semi-conductrice, dans laquelle la relation de dépendance de l'épaisseur de couche d'une couche à l'égard de la position verticale (z) est prédéfinie par une fonction commune pour toutes les couches de la grille supérieure (9).

5. Structure stratifiée semi-conductrice selon l'une quelconque des revendications 1 à 3, dans laquelle une position verticale (z) est associée à des couches individuelles de la grille supérieure (9) à l'intérieur de la structure stratifiée semi-conductrice et l'épaisseur de couche d'une couche dépend de sa position verticale (z) à l'intérieur de la structure stratifiée semi-conductrice, dans laquelle la relation de dépendance de l'épaisseur de couche d'une couche à l'égard de la position verticale (z) est prédéfinie par une première fonction pour des couches du premier type (a) et par au moins une deuxième fonction pour des couches dudit au moins un deuxième type (b).

6. Structure stratifiée semi-conductrice selon une des revendications 4 ou 5, dans laquelle la première fonction et/ou ladite au moins une deuxième fonction et/ou la fonction commune est/sont une fonction en gradins ou une fonction croissant ou décroissant de façon monotone ou une fonction linéaire ou une fonction parabolique ou une fonction exponentielle ou une fonction logarithmique ou une fonction périodique ou une superposition desdites fonctions, ou contien(nen)t des parties d'une de ces fonctions.

7. Composant optoélectronique, qui présente une structure stratifiée semi-conductrice selon l'une quelconque des revendications 1 à 6.

8. Composant optoélectronique selon la revendication 7, qui est une diode luminescente.

9. Composant optoélectronique selon la revendication 7, qui est une diode laser.
